Europäisches Patentamt

European Patent Office

Office européen des brevets

(19)

(11) Publication number: **0 262 252 B1**

# EUROPEAN PATENT SPECIFICATION

(12)

(45) Date of publication of patent specification: **29.04.92**   (51) Int. Cl.5: **H05K 7/14**

(21) Application number: **86113659.6**

(22) Date of filing: **03.10.86**

(54) Retention apparatus for retaining an object in a predetermined position.

(43) Date of publication of application:
 **06.04.88 Bulletin 88/14**

(45) Publication of the grant of the patent:
 **29.04.92 Bulletin 92/18**

(84) Designated Contracting States:
 **CH DE ES FR GB IT LI NL SE**

(56) References cited:
 **EP-A- 0 121 000**
 **EP-A- 0 122 974**
 **EP-A- 0 130 556**
 **DE-U- 1 979 162**
 **FR-A- 1 531 419**

 **IBM TECHNICAL DISCLOSURE BULLETIN, vol.
 25, no. 3B, August 1982, pages 1410-1411,
 IBM, New York, US; O.I. CHIRINO et al.:
 "Semi-automatic card insertion device"**

(73) Proprietor: **International Business Machines
 Corporation
 Old Orchard Road
 Armonk, N.Y. 10504(US)**

(72) Inventor: **Poch, Leonard John
 2015 Main Street**
 **Vestal New York 13850(US)**
 Inventor: **Progovitz, Richard Francis
 37 Elizabeth Street
 Johnson City New York 13790(US)**
 Inventor: **Salacka, Frank Stephen
 7 Woodside Road East
 Apalachin New York 13732(US)**
 Inventor: **Stanton, Kimball Andrew
 1501 Campus Drive
 Binghamton New York 13903(US)**
 Inventor: **Stubecki, John Arthur
 Rd. No. 1, Box 549
 Nichols New York 13812(US)**
 Inventor: **Werbizky, George Gregory
 409 Jones Road
 Vestal New York 13850(US)**
 Inventor: **Winkler, Paul Edward
 217 Meeker Road
 Vestal New York 13850(US)**
 Inventor: **Adams, Kirk Duane
 Rd. No. 2, Box 199B
 Laceyville Pennsylvania 18623(US)**
 Inventor: **Albrechta, Joseph, Jr.
 Rd. No. 2, box 94C Stuart Road
 Conklin New York 13748(US)**

EP 0 262 252 B1

Inventor: **Babuka, Robert**
**128 Hawthorne Street**
**Vestal New York 13850(US)**
Inventor: **Beaudry, John Samuel, Jr.**
**929 Schuyler Street**
**Endicott New York 13760(US)**
Inventor: **Arvanitakis, Nicolaos Constantine**
**924 Chestnut Lane**
**Vestal New York 13850(US)**
Inventor: **Bocinski, Terrence Edward**
**Wilson Hill Road Box 300A, Rd. No. 5**
**Binghamton New York 13905(US)**
Inventor: **Cosimano, Raymond Joseph**
**500 Exchange Avenue**
**Endicott New York 13760(US)**
Inventor: **English, John Jones**
**Rd. No. 1, Box 58**
**Hallstead Pennsylvania 18822(US)**
Inventor: **Kman, Stephen Joseph**
**Rd. No. 1, Box 121**
**Port Crane New York 13833(US)**
Inventor: **McKeown, James Edward**
**328 Rayelene Drive**
**Vestal, New York 13850(US)**
Inventor: **Petrozello, James Ralph**
**925 Hill Avenue**
**Endicott New York 13760(US)**
Inventor: **Piechota, John Lawrence**
**1105 Ford Road**
**Vestal New York 13850(US)**

(74) Representative: **Klocke, Peter, Dipl.-Ing.**
**IBM Deutschland GmbH Patentwesen und**
**Urheberrecht Schönaicher Strasse 220**
**W-7030 Böblingen(DE)**

## Description

This invention relates to a retention of an object, for instance, a printed circuit card in a predetermined position.

Printed circuit (PC) cards or boards, which have input/output (I/O) tabs, i.e. pads, located on both planar surfaces of the card and are arranged on each of the planar surfaces in one or more rows that are parallel and adjacent to at least one of two parallel edges of the card, are well known in the art. The I/O tabs mate with the contacts of an edge type connector into which the card edge adjacent to the I/O tabs is inserted. One particular type of edge connector used for this purpose is referred to in the art as a zero insertion force connector and alternatively as a ZIF connector or simply as a ZIF.

One of the technologies for packaging electronic component assemblies employing PC cards is referred to in the art as card on board or simply as COB technology. In this technology, a series or plurality of PC cards, sometimes referred to in the art as daughter cards or boards, are mounted in planar parallel spaced relationship with respect to each other and in an orthogonal relationship with respect to the planar of at least one PC board, sometimes referred to in the art as the mother board(s). Typical COB arrangements, for example, provide a single mother board with its planar normal, i.e. at a right angle, to one of the commonly aligned edges of the parallel aligned rectangular shaped daughter cards, or provide in addition thereto a second mother board which has its planars aligned in a spaced parallel relationship with respect to the first mother board and normal to the opposite commonly aligned edges of the parallel aligned daughter cards, the cards being thus disposed between the two boards. Interconnection between the daughter cards and the mother board(s) takes place through suitable connectors, such as, for example, the aforementioned edge type connectors in general and the aforementioned ZIF connectors in particular.

Retention apparatus for retaining the PC card in a predetermined position are well known in the art. Heretofore, in the retention apparatus of the prior art, the card was often susceptible to some movement when being retained thereby. That is to say, if the card was being restrained from movement in, for example, one degree of motion by the retention apparatus, the card was often nonetheless susceptible to movement in one or more of the other five degrees of motion. In the case of certain COB applications employing ZIF connectors and PC cards with I/O tabs arranged in one or more parallel rows on both planar surfaces of the card and along a common edge of the card or along two parallel edges of the card, the alignment of the card in a predetermined position is critical for proper registration with the mating contacts of the ZIF connectors.

For example, in U. S. Patent 4,480,884 there is described a retention system that retains the printed circuit I/O tabs, which are located on opposite surfaces of a PC card and adjacent to a common edge of the card, in contact with the flexible spring contacts of a ZIF connector. The spring contacts are aligned in opposing rows in the connector. The card edge adjacent to the tabs is inserted between the two rows of open contacts and retained therein by a retention system consisting of two sets of a pin and open slot each. The pin and slot of one set are located on the card and connector, respectively, and the pin and slot of the other set are located in the connector and card, respectively, each set being associated with a mutually exclusive one of the two opposite ends of the last mentioned edge of the card. With the card properly inserted, the pin of each set engages the slot of the corresponding set and thus prevents movement of the card when the mechanism for closing the contacts is actuated causing the contacts to wipe their respective associated tab. Thus, the aforedescribed system was generally satisfactory to prevent the movement of the card in the horizontal and vertical directions, which two last mentioned directions are coplanar with the plane of the card, when the spring contacts were closed.

However, it was found that the wiping forces produced by closing the ZIF contacts could cause micro-movement of the card. More particularly, the wiping forces produced a torque causing the card to rotate about an axis orthogonal to the horizontal and vertical directions, that is to say an axis normal to the plane of the card. As a result, electrical contact between the I/O tabs would move away from he connector spring contacts causing loss of contact between the two and a concomitant open circuit. By designing the system with acceptable tolerances, the micro-movements of the card could be accommodated without losing electrical contact between the tab and its associated contact. However, with the advent of higher density edge card connector systems and/or smaller I/O tab and ZIF contact wipe areas and/or greater wipe forces, there is a need for improved retention apparatus to provide for more stringent alignment of the I/O tabs of the card and the contacts of the connector and/or to mitigate and/or prevent micro-movement of the card such as may be caused, for example, by the wiping forces produced when the spring contacts are actuated from their open to closed position, and/or to mitigate loss of contact between the mating I/O tabs and spring contacts, and which improved apparatus heretofore was not available in the prior art.

By way of example, in US Patents 4,480,884, 4,499,523 and 4,548,452 there are described typical PC cards or boards with edge located I/O tabs and mating ZIF connectors. Furthermore, by way of example, in the aforementioned US Patent 4,458,452 there is described a typical COB type arrangement, and in the aforementioned US Patent 4,499,523 there is described a typical cassette type housing unit for a PC card with edge located I/O tabs.

The invention as claimed is intended to remedy the aforementioned drawbacks. It solves the problem of providing improved retention apparatus for retention of an object that substantially mitigates or prevents the movement of the object and/or is highly reliable.

In the following the invention is described in detail with reference to the drawings, of which:

FIG. 1

is a schematic perspective view of a preferred embodiment of the electronic component assembly for printed circuit cards and the retention apparatus therefore of the present invention;

FIG. 2

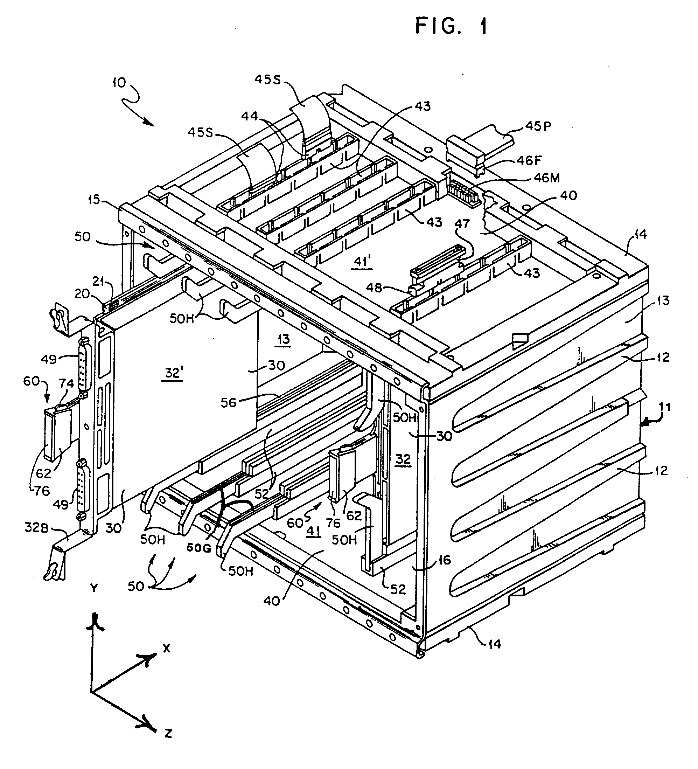

is a schematic perspective view of the preferred embodiment of the PC card housing cassette assembly and the retention apparatus of FIG. 1;

FIG. 3

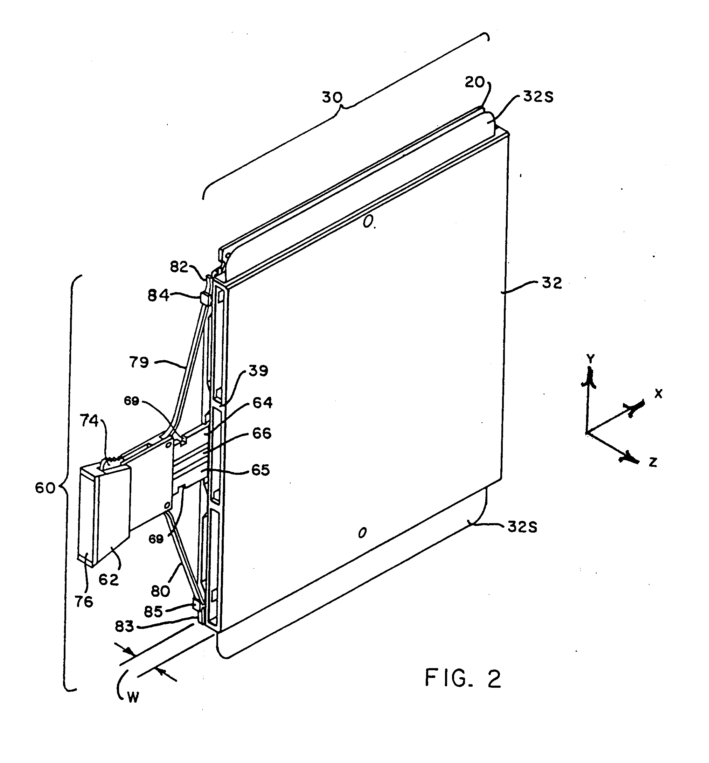

is an exploded schematic perspective view, partially broken away for sake of explanation, of the PC card housing cassette assembly of FIG. 2;

FIG. 4A

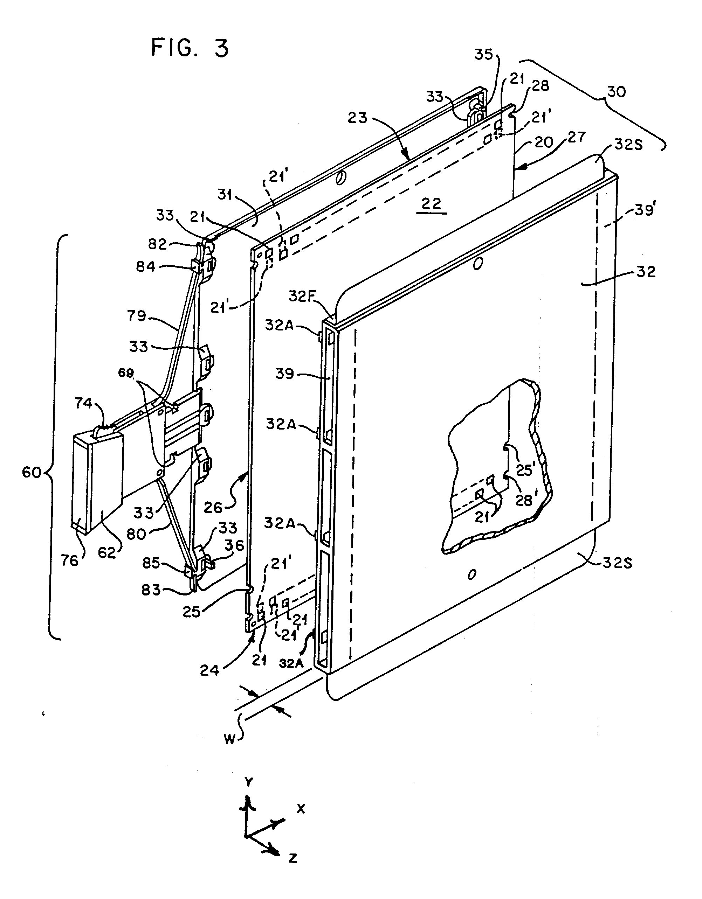

is a schematic perspective view of the side cover of the PC card housing cassette assembly of FIGS. 2 and 3;

FIGS. 4B, 4D and 4F

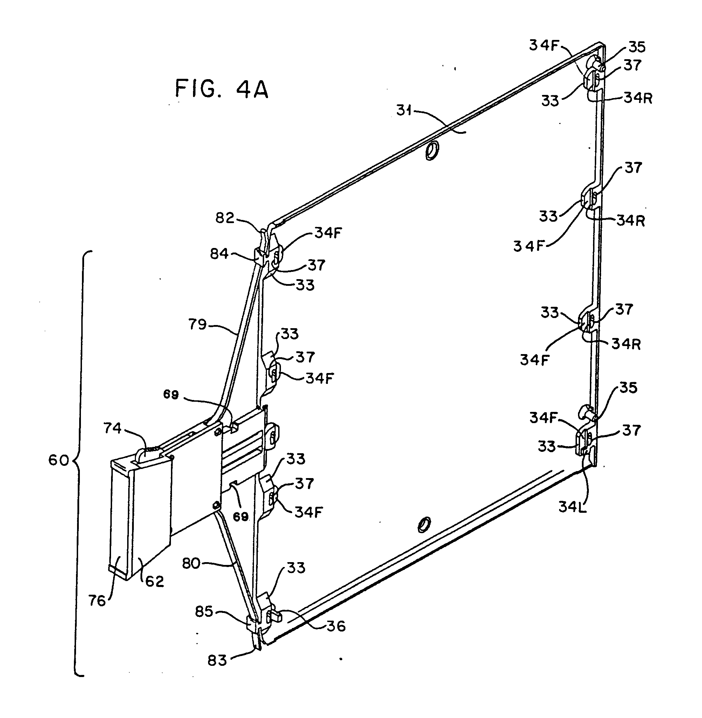

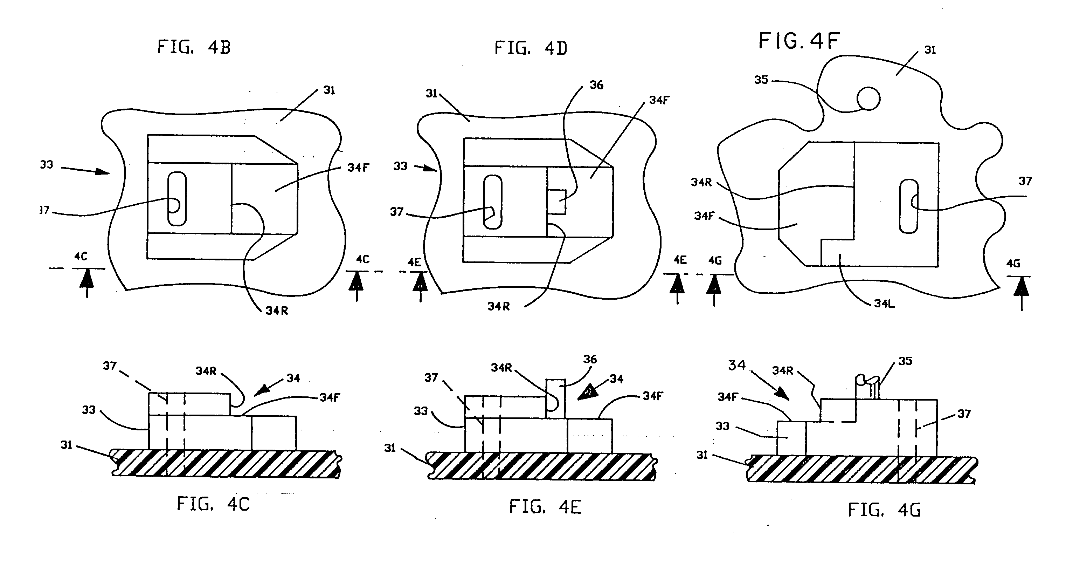

are enlarged partial plan views of different details of the side cover of FIG. 4A;

FIGS. 4C, 4E and 4G

are cross sectional views taken along the lines 4C-4C, 4E-4E and 4G-4G, respectively, of FIGS. 4B, 4D and 4F, respectively;

FIG. 5

is an exploded schematic perspective view of the retention apparatus of FIG. 2;

FIGS. 6 and 7

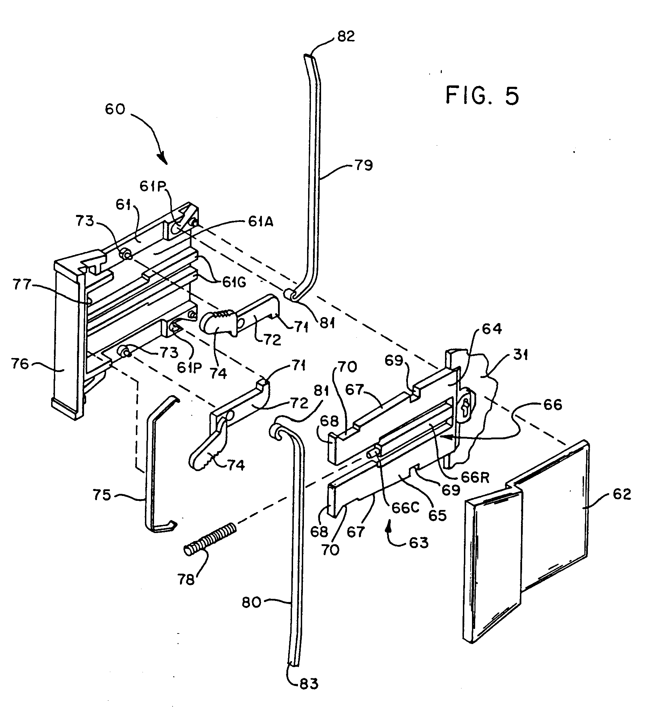

are partial schematic side views of the retention apparatus of FIGS. 1 and 5 illustrating the relative position of its elements when the retention apparatus is in its retention and withdrawn positions, respectively;

FIGS. 8A and 8B

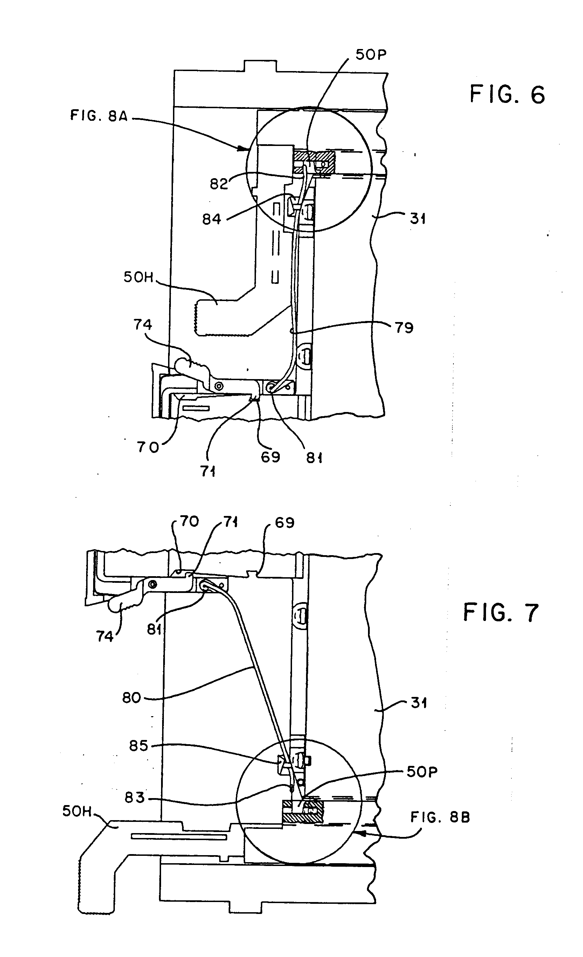

are enlarged views of the apparatus of FIGS. 6 and 7, respectively, shown within the circles designated 8A and 8B, respectively, thereof;

FIG. 9A

is an enlarged cross sectional schematic view of a ZIF connector of the assembly of FIG. 1;

FIG. 9B

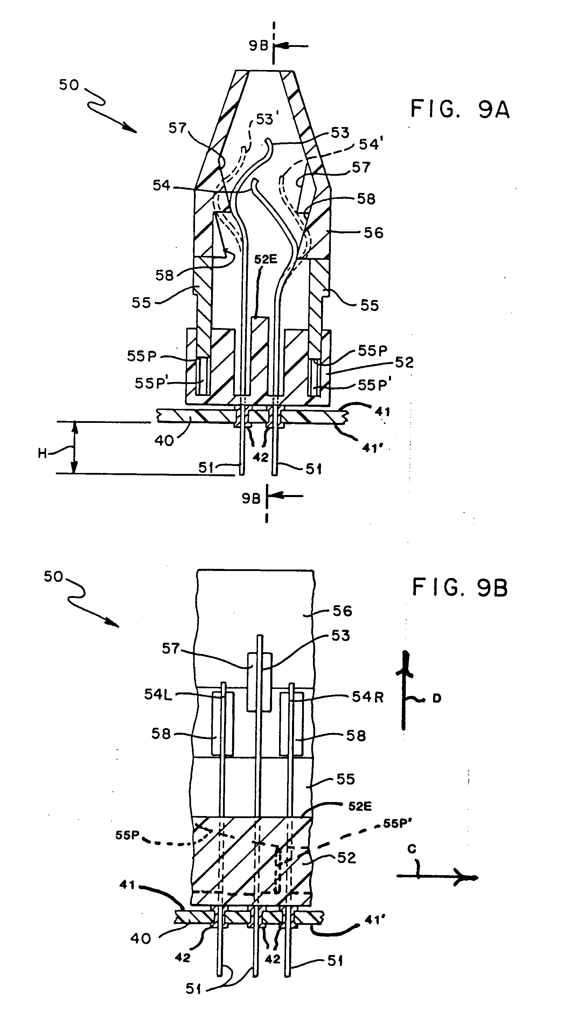

is an enlarged partial schematic view of the ZIF connector of FIG. 9A taken along the line 9B-9B thereof with the contacts of the ZIF connector in their open position; and

FIG. 10

is another embodiment of the retention apparatus of the present invention.

In the figures, like elements are designated with similar reference numbers.

Referring to FIG. 1, there is shown a preferred embodiment of the electronic component assembly and retention apparatus therefor, generally indicated by the reference numbers 10 and 60, respectively, of the present invention. Assembly 10 is configured in card on board technology. Briefly, in assembly 10, plural printed circuit cards 20 are housed in individual cassettes 30. Each card 20, hereinafter sometimes referred to as daughter cards, is interconnected to two planar multilayer printed circuit boards 40, hereinafter sometimes referred to as mother boards, by a pair of coaligned ZIF connectors 50, each of which is mounted to a mutually exclusive one of the two boards 40. For sake of clarity only two of the cassettes 30 and only four of connectors 50 are shown on each board 40 in FIG. 1. As explained in greater detail hereinafter, retention apparatus 60 is provided with each cassette 30 and retains the printed circuit card 20 that is mounted therein in a predetermined position that substantially mitigates and/or prevents movement of the particular card 20 when the spring contacts, cf. contacts 53 and 54, FIG. 9A, of the mating ZIF connector 50 are actuated.

Referring now to the assembly 10 in greater detail, an integral U-shaped rigid plastic molded channel-like frame 11 has integrally molded ribs 12 formed on the outer surfaces of its two lateral, i.e. side, walls 13. Preferably, the frame 11 is selected to have a thermal coefficient of expansion which compatibly matches that of the cards 20 so as to minimize relative motion between the two. The base, i.e. rear or back wall, of frame 11 is integral with and between the two side walls 13 as viewed facing FIG. 1, and, hence, is not seen therein. This back wall has a substantial rectangular aperture, not shown, to allow forced air from an external cooling system, not shown, to pass there through. Frame 11 has mounted to its upper and lower open ended sides respective upper and lower molded picture-framelike stiffener members 14, which are preferably made of the same material as frame 11. Mounted inwardly to upper and lower members 14 are upper and lower boards 40, respectively. Members 14 provides support and stiffness to the respective board 40 mounted thereto which mitigates and/or prevents flexure of the particular board 40 when the ZIF connectors 50 that are mounted to the particular board 40 are actuated. By sandwiching the boards 40 between the frame 11 and members 14, assembly 10 can accomodate boards 40 of different thickness sizes. If desired, members 14 may be provided with reinforcement bars, not shown, to further enhance the stiffness and/or support of its particular board 40. Another picture-framelike member 15 is mounted to the front open end 16 of the frame 11. With the aid of its retention apparatus 60, each of the cassettes 30 is inserted and withdrawn through opening 16 for insertion and withdrawal, respectively, of the cards 20 mounted therein into and out of the ZIF connectors 50. The members 11-16 and the aforementioned apertured back wall, not shown, in conjunction with the boards 40 provide assembly 10 with a hollow rectangular tube and box-like configuration.

Referring now to FIGS. 2-3, in the preferred embodiment, each card 20 has rectangular planar configuration with plural edge located I/O pads or tabs 21 on its surface 22. More particularly, the tabs 21 are aligned in two pairs of parallel rows, the tabs 21 of one row of each pair being interleaved with respect to the tabs 21 of the other row of the same pair. Each pair of rows of the tabs 21 is located adjacent and parallel to one of the two opposing parallel sides of card 20, cf. the upper and lower edges 23 and 24, FIG. 3.

It should be understood, as is well known to those skilled in the art, that tabs 21 are part of and formed with the printed circuitry on surface 22 of the card 20, which printed circuitry includes PC conductors connected to tabs 21 that interconnect with the PC lands of the plated thru holes (PTHs) and/or vias of the multilayer card 20, and/or with the I/O pads located at the mounting sites on surface 22 for the circuit module and/or other components, the last mentioned PC conductors, PC lands, PTHs, vias, I/O pads, mounting sites, as well as other conductors of the aforementioned printed circuitry on surface 22 being omitted for sake of clarity. Surface 22, hereinafter sometimes referred to as the populated surface, is populated with one or more mounted thereto integrated circuit chip module components and other type components, also omitted in the Figures for sake of clarity.

The opposite surface, not shown, of card 20 is unpopulated but, it should be understood, has its own personalized PC circuitry or pattern of PC conductors, PTH lands and via lands. In addition, on the opposite card surface, hereinafter sometimes referred to as the unpopulated surface of card 20, as part of the PC circuitry threat, are plural edge located I/O tabs 21′, partially shown in phantom outline in FIG. 3 for sake of explanation. More particularly, tabs 21′ are aligned in two pairs of parallel rows, the tabs 21′ of one row of each pair being interleaved with respect to the tabs 21′ of the other row of the same pair. Each pair of rows of tabs 21′ is located adjacent and parallel to one of the upper and lower edges 23 and 24 of the two opposing parallel sides of card 20. Each row of tabs 21′ is coaligned with one of the rows of tabs 21 of the surface 22. The tabs 21′ of each row, moreover, are interleaved with the tabs 21 of its coaligned counterpart row as shown in FIG. 3.

Card 20 has a locator slot 25 and 25′ located along its trailing and leading edges 26 and 27, respectively, cf. FIG. 3. Slots 25 and 25′ help locate the card 20 in cassette 30, as is hereinafter described. Near the top of the leading edge 27 of card 20 there is a fine tolerance guide and locator slot 28, referred to herein sometimes as upper slot 28, cf. FIG. 3. A similar, but gross or coarse tolerance guide and locator slot 28′, referred to herein sometimes as lower slot 28′, cf. FIG. 3, is located near the bottom of leading edge 27 and is in vertical alignment with the fine tolerance slot 28. Upper slot 28 and its lower coarse tolerance counterpart slot 28′ help guide and locate the card 20 in the upper and lower aligned ZIF connectors 50, which are mounted on the upper and lower boards 40, respectively, and with which the edge located tabs 21 and 21′ of the card 20 are mated. Each connector 50 is provided with a stop pin, not shown, located transverse to the elongated axis of the connector 50 on the end opposite the one to which the handle 50H is mounted. The last mentioned pins of the upper and lower paired connectors 50 coact with the guide and locator slots 28 and 28′, respectively, and as such as the card 20 advances sideways into the pair of ZIF connectors 50, the card locator slots 28 and 28′ are engaged by the respective card locator pins of the upper and lower ZIF connectors 50, respectively, in a manner well known to those skilled in the art. The locator pin, not shown, of the lower connector 50 provides coarse location of the card 20 in the Y direction but fine or precise location of the card 20 in the X direction. On the otherhand, the locator pin, not shown, of the upper connector 50 provides fine or precise location of the card 20 in both the X and Y directions.

As aforementioned, each card 20 is housed in a cassette 30, shown in greater detail in FIGS. 2-3 and partially in FIGS. 4A-4G. More pa rticularly, card 20 is housed between the molded plastic side cover 31 and the component metal side cover 32 of cassette 30 such that the aforementioned unpopulated surface, not shown, of card 20 faces cover 31 and the populated surface 22 faces cover 32. Cover 31 has two rows of aligned edge located pedestals 33, cf. FIG. 4A. The pedestals 33, cf. FIGS. 4C, 4E, 4G, have recessed steplike portions 34 on the flat 34F of which the aforementioned unpopulated surface of the card 20 is seated with the trailing and leading edges 26 and 27 of the card 20 in abutment with the aligned rises 34R of the steplike portions 34 the pedestals 33 of the left and right rows, respectively, thereof as viewed facing FIG. 4A. In addition, the steplike portion 34 of the lower pedestal 33 of the right row has a right angle corner locator 34L, FIG. 4F, which engages and locates the locator slot 25' on the leading edge 27 of card 20. Locator pins or stops 35, cf. FIGS. 4A, 4F, 4G, are in alignment with the rises 34R of the steplike portions 34 of the right row of pedestals 33. Cover 31 has a locator post 36, FIGS. 3, 4A, 4D, 4E, which coacts with the locator slot 25 on the edge 27 of card 20. Post 36 is abutted against the rise 34R of the steplike portion 34 of the lower pedestal 33 of the left row. The system of steplike portions 34, guides 35, and locator 34L and post 36 thus properly seats the card 20 in the cassette 30 and together coact to keep the card 20 in alignment in cassette 30 once the locator slots 25 and 25' of card 20 are inserted onto the locator post 36 and right angle locator 34L, respectively.

Pedestals 33 have apertures 37, cf. FIGS. 4A-4G, for receiving the deformable mounting tabs 32A, FIG. 3, located in two rows on the cover 32, the right row of mounting tabs being blocked from view in the Figures. After the card 20 is properly seated in the cassette 30 as aforedescribed, cassette 30 is assembled by inserting the tabs 32A into the respective one of the aligned apertures 37 and thereafter bending back the protruding tips of the tabs 32A to securely fasten or clasp the assembly together, i.e. the assembly which includes side cover 31 and component cover 32 with the card 20 therebetween. Cover 32 is U-shaped having an upper flange 32F, FIG. 3, and lower flange, not shown. With the card 20 properly located and seated in the cassette 30, the card 20 extends outwardly beyond the upper and lower flanges 32F of the cover 32 so that the rows of edge located I/O tabs 21 and 21' are exposed, that is to say are located on the upper and lower extension strips of the card 20 that extended outside the cassette 30. Affixed to cover 32 as parts thereof and adjacent to the trailing and leading edges 26 and 27 of card 20 are elongated apertured metal supports 39 from which depend the aforementioned integral metal tabs, cf. tabs 32A, the right support being blocked from view in FIG. 2 but shown on outline form 39' in FIG. 3 for sake of clarity. Metal U-shaped cover 32 and its affixed supports 39 when assembled to the cover 31 acts as a heat sink and cooling duct through which the aforementioned forced air passes, thus cooling the card 20 and components, not shown, that are mounted on the populated surface 22 of the card 20 and located inside the cover 32 of the cassette 30.

Conductive EMI shields 32S are affixed to side cover 32 to provide electro-magnetic interference shielding to the card 20 in the cassette 30 along the I/O tabs 21 and 21'. The width W, cf. FIG. 3, of the flange 32 of cover 32 is judiciously selected to accommodate the height of the aforementioned components, not shown, that are mounted on the populated surface 22 of the card 20 and which together with the card 20, in the manner aforedescribed, are covered by the cover 32 and inside the cassette 30. By way of comparison, the cover 32 of the cassette 30 shown on the right in FIG. 1 is used to accommodate components with a low height profile; whereas, the wider cover 32' of the cassette 30 shown on the left in FIG. 1 is used to accommodate components with a relatively higher height profile.

Referring again to FIG. 1, and with reference to FIGS. 9A and 9B, printed circuit boards 40 have planar rectangular configurations, and are laminated epoxy glass types with multiple signal and power layers, not shown for sake of clarity. The multilayer boards 40 have a grid array of plated thru holes or vias 42, FIGS. 9A and 9B. Mounted on the inner surfaces 41 of boards 40 as viewed facing the frontal opening 16 of assembly 10 are the ZIF connectors 50, the inner surface of the upper board 40 being obstructed from view in FIG. 1. As shown in FIGS. 9A and 9B, the conductor stems or pins 51 of ZIF connectors 50 are solder bonded in the plated thru holes 42 of board 40. The pins 51 are affixed, for example, by molding them into the base 52, or, alternatively, by force fit insertion thereof into the insulator base 52 of connector 50.

The pins 51 are arranged in the base 52 in two opposing elongated parallel rows arranged on opposite sides of the center line 9B - 9B, FIG. 9A. In each of the pin rows, the pins 51 have alternate long and short lengths which depend from the alternate upper and lower spring contacts 53 and 54, respectively. For sake of explanation, the left row of pins 51, as viewed facing FIG. 9A, is partially shown in FIG. 9B. The left and right lower contacts of the short pins 51, as viewed facing FIG. 9B, are located adjacent to a long pin 51 that depends from an upper contact 53, and the short pins 51 depend from the lower contacts designated by the reference characters 54L and 54R, respectively, in FIG. 9B. The contacts 53 of the long pins 51 of the same pin row are aligned with respect to each other. Likewise, the contacts 54 of the short pins 51 of the same pin row are aligned with respect to each other. The contacts 53 and 54 of a given row of pins 51 mate with the inner and outer rows, respectively, of the edge located tabs 21 or 21', as the case may be, of card 20. Moreover, as shown in FIG. 9A, each pin 51 of the same row of pins 51 is oppositely aligned with one of the pins 51 of the other row of pins 51, hereinafter sometimes referred to as an opposed contact pin pair, and such that for each opposed contact pin pair, the contact 53 of a long pin 51 in one row is opposed to the contact 54 of a short pin in the other row. Pin 51 may be integrally formed with its contact 53 or 54 as shown in FIGS. 9A and 9B; or, alternatively, may be formed as a discrete member which is affixed to the contact 53 or 54 by any suitable means such as, for example, bonding, brazing, etc.

The pins 51 extend outwardly from the connector base 52 in a compatible grid pattern that allows its ZIF connector 50 to plug into the aforementioned through vias or PTHs 42 of the boards 40 at the surfaces 41, thereby mounting and electrically connecting the ZIF connector 50 to the particular board 40 in conjunction with the aforementioned solder bonding associated therewith. If desired, additional fastening means may be used to enhance mounting the connectors 50 to the boards 40 such as, for example, screws or the like, not shown, which fasten the base 52 to the board 40.

A compound cam system is used in the ZIF connector 50 to actuate the contacts 53 and 54 into their closed and open positions, whereby the contacts 53 and 54 of each opposed contact pair are positioned towards and away, respectively, from each other. In the primary system of the compound cam system, ZIF connector handle 50H, which is pivotally mounted to the fixed base 52, is linked to slideable elongated linear cams 55. The lower edge of the cams 55 are contoured with a configuration of multiple symmetrical ramp or lobe shaped cam surfaces, only one lobe surface 55P of which is shown in outline form in FIG. 9B for sake of explanation. Integrally formed with and extending upwardly from base 52 is a corresponding multiple of cam follower posts 55P'. Each of the lobe surface s 55P rides on a mutually exclusive one of the cam follower posts 55P'. Rotation of the handle 50H about its pivot axis from its open position, cf. horizontal position shown in FIG. 1, towards its closed position, cf. vertical position shown in FIG. 1, causes the linear cams 55 to move in a horizontal direction, cf. arrow C, parallel to the longitudinal axis of the connector 50, i.e. normal to the plane of FIG. 9A. For sake of explanation, it will be assumed that the cams 55 move inwardly towards the end of ZIF connector 50 that is opposite its handle end. In response to this horizontal linear motion of the cams 55 and for the assumed direction, cf. arrow C, the cam ramp or lobes 55P ride on cam posts 55P' causing the upper cam follower 56, which houses the contacts 53 and 54, to move in a vertical direction, cf. arrow D, such that the follower 56 moves vertically away from the board 40 to which the base 52 of connector 50 is mounted. Juxtaposed to each of the spring contacts 53 and 54 are inclined cam surfaces 57 and 58, respectively, which are contained within and are integrally formed on each of the inner longitudinal walls of follower 56.

Follower 56 and its surfaces 57 and 58 are the secondary cam system of the aforementioned compound cam system of the ZIF connector 50. The contacts 53 of long pins 51 and the contacts 54 of short pins 51 are self-biased outwardly, i.e. away from center line 9B-9B, against the surfaces 57 and 58, respectively. As a result, when the follower 56 moves in the vertical direction away from board 40 in response to the primary cam system, the secondary cam system, i.e. the inclined cam surfaces 57 and 58, move the contacts 53 and 54 of the respective opposed contact pin pairs towards the center line 9B-9B.

In FIGS. 9A and 9B, the printed circuit daughter card 20 is removed from connector 50, that is to say is not in the connector 50. ZIF connector 50 as shown in FIG. 9A is in its actuated position, i.e. closed position. As such, its moveable linear cams 55 vertically position its upper housing 56 away from the mother board 40 to which its lower housing, i.e base, 52 is mounted. As a result, the inclined cam surfaces 57 and 58, which are contained within and are part of cam follower 56, force, i.e. urge, contact 53 of long pin 51 and contact 54 of short pin 51, respectively, toward the center line 9B-9B of connector 50, cf. FIG. 9A, the center line 9B-9B being substantially coplanar with the insertion path of card 20.

In FIG. 9A, an opposed pair of contacts 53 and 54 of contact pins 51 are shown in solid outline form and corresponds to the position of the two opposed contacts 53 and 54 after the ZIF connector is actuated to the closed position and without a card 20 being present in the ZIF connector 50. In the closed position of the connector 50, its handle 50H is in the vertical position as viewed facing FIG. 1. As such, the opposed contact pair 53-54 have passed through center line 9B-9B. Actuation of the connector 50 to its closed position causes the linear cam 55 of the connector 50 to move in a direction normal to the plane of FIG. 9A, thereby allowing follower 56 to move vertically away from board 40, as aforementioned, and as a result, the cam faces 57 and 58 urge the opposed pairs of contacts 53 and 54 towards center line 9B-9B. However, as shown in FIG. 9A, they do not touch one another as the contact 54 of short pin 51 is under contact 53 of long contact pin 51.

It should be noted that not all of the contacts 53 and 54 of all of the aforementioned opposed contact pin pairs of every connector 50 must pass through center line 9B-9B. The mechanical tolerances may accumulate such that none or only some of the contact 53 and 54 pass through center line 9B-9B in any one given connector of a production lot. However, in another given connector, mechanical tolerances may accumulate such that all contacts 53 and 54 of all opposed contact pin pairs pass through center line 9B-9B. The offset pin configuration of the opposed contact pin pair is such that no opposed contact pins 53 and 54 will touch and short circuit each other in any connector 50 of the production lot. As such, in the absence of a card 20 in the ZIF connector 50, closure of the opposing contacts 53 and 54 towards center line 9B-9B will not cause them to short circuit each other and adversely effect the operation of the rest of the associated circuitry.

The contacts 53 and 54 when they are in the retracted position, i.e. their open position, are shown in FIG. 9A in phantom outlines $53'$ and $54'$, respectively, and corresponds to the position of the two opposed contacts 53 and 54 after the ZIF connector 50 is returned to its open position. In the open position of the connector 50, its handle 50H is in the horizontal position as viewed facing FIG. 1. Thus, rotation of the handle 50H from its vertical position to its horizontal one, causes the linear cams 55 to move in respective horizontal directions, i.e. opposite to arrow C. As a result, the cams lobes 55P ride on the cam posts $55P'$ causing the cams 55 to move the cam follower 56 vertically towards board 40, i.e. opposite to arrow D. The contacts 53 and 54 biased against the secondary inclined cam surfaces 57 and 58 of follower 56 are, thus, moved outwardly away from the center line 9B-9B as the surfaces 57 and 58 correspondingly move towards the board 40. In their retracted positions, contacts 53 and 54 are positioned away from the center line 9B-9B, thereby providing clearance between the opposed pairs of contacts 53 and 54 to allow the passage of a printed circuit card 20 sideways, that is to say in the direction of the longitudinal axis of the connector 50, without being obstructed or interfered with by the opposed pairs of contacts 53 and 54. Card guide channels 50G, FIG. 1, on the handles 50H, when in their open, i.e. horizontal position, are aligned with the insertion path of the card 20, the path being orthogonal to the center line 9B-9B.

Connectors suitable for use as the ZIF connectors 50 herein and their interrelationship with the cards 20 and boards 40 are well known to those skilled in the art. By way of example, one such connector suitable for such use is described in the aforementioned United States Patent No. 4,548,452, incorporated herein by reference, and to which the reader is referred for further details and description. Accordingly, the description of ZIF connectors 50 are omitted herein for sake of clarity and brevity.

Preselected ones, not shown, of the pins 51 of the ZIF connectors 50 terminate at or below the outer surface $41'$ of the boards 40, i.e. within the via 42; whereas, others extend uniformly for a given distance H, cf. FIG. 9A, outwardly from the outer surfaces $41'$, as shown in FIGS. 9A and 9B. The so extended pins 51 pass through the individual openings, not shown, in the base of an insulator pin shroud member 43, FIG. 1, for connection to plugable mating female connectors 44 that are connected to the end of a suitable multiwire cables such as, for example, the partially shown signal flat wire cables 45S shown in FIG. 1. Boards 40 also have affixed and connected thereto power connectors, e.g. male pin connectors 46M, into which are plugged mating female connectors, e.g. female connectors 46F, affixed to power cabling such as the partially shown power flat wire cable 45P. Also connected, to some of the protruding pins 51 of the ZIF connectors 50 are passive components, e.g. axial lead decoupling capacitor 47, which is mounted on electrical connector 48, the right angle bent leads, not shown, of capacitor 47 being electrically connected to female terminals, not shown, of connector 48 that plug into the last mentioned ZIF connector pins 51. Cabling can also be provided directly to the cards 20 of the cassettes 30, if desired. For example, mounted to bracket 32B, which is affixed to side cover $32'$ of its cassette 30, are two conventional D-type connectors 49 which are connected by discrete wires, not shown, to suitable internally located I/O pads, not shown, on the surface 22 of card 20 and which are covered by cover $32'$. Mating connectors, not shown, connected to the end of cabling, not shown, plug into the connectors 49 thereby bringing signal and/or power directly to the card 20 in the cassette 30.

Retention apparatus 60 will next be described with reference to FIGS. 2-4A, 5-7, 8A-8B. Apparatus 60 has a hollow handle-like configuration which is formed by the molded plastic handle base or side member 61, FIG. 5, and the molded plastic cover or member 62 that is affixed to member 61 by suitable means such as, for example, screws, not shown. The handle 61-62 is slideably mounted on the molded handle guide 63 that extends outwardly from the side cover 31 of cassette 30. Guide 63 may be formed as a discrete member affixed to the cover 31 by suitable means, e.g. by configuring the interfacing edges of the members 31 and 63 in a dovetail snap-on interlocking relationship. Alternatively, guide 63 may be integrally formed with the molded side cover 31. Guide 63 has a pair of upper and lower outer guide rails 64 and 65 and a center inner rail 66. The outer edges 67 of the rails 64 and 65 are symmetrically tapered inwardly towards their free ends 68. Center rail 66 has a rectangular cross section portion 66R and an integral concentric cylindrical post 66C extending outwardly therefrom.

The inner surface 61A of member 61 has a pair of spaced elongated glides 61G which in the assembled handle 61-62 are interleaved with the three guide rails 64, 65 and 66. That is to say, upper glide 61G is slideably mounted between upper rail 64 and center rail 66 of guide 63, and lower glide 61G is slideably mounted between lower rail 65 and center rail 66. The respective sliding interfaces between the rails 64-66 and the glides 61G are compatibly contoured.

Each outer edge 67 of the respective rails 64 and 65 has a pair of detent notches or recesses 69 and 70, which pair of recesses 69 and 70 coacts with the detent 71 formed on one end of the adjacent one of the two lever members 72. The other ends of the levers 72 are pivotally mounted on one of the pivot shafts or posts 73 that extend outwardly from surface 61A and are integrally formed with the member 61. A pair of gripping members 74, each of which is integral with and extends outwardly and offset from one of the levers 72 at the pivot end of the particular lever 72, are inwardly biased towards the respective adjacent one of the edges 67 by a C-shaped flat bias spring 75. The center portion of spring 75 is seated and mounted in a snug fit relationship between the outer right angle side wall 76 of member 61 and parallel inner wall 77 which extends outwardly from the inner surface 61A and is integrally formed with the member 61. An elongated coil spring 78 is concentrically mounted in a cantilever manner to the post 66C of center rail 66 and its free end is seated against the inner wall 77. The spring 78, which is in a compressed state when the detents 71 are in the notches 69, upon release of the detents 71 therefrom, which is caused by squeezing the gripping members 74 towards each other, returns the side member 61 and hence the levers 72 carried thereby to its retracted position, whereupon the detents 71 engage notches 70 by the biasing action of the spring 75.

In conjunction with the retention of the card 20 in the upper and lower ZIF connectors 50, a resilient member, which in the preferred embodiment, is configured as two J-shaped flat elongated bow springs 79 and 80, respectively, extends outwardly from and is carried by the side cover 61. More particularly, side cover 61 has a pair of pockets 61P, FIG. 5, which are compatibly contoured with the coiled ends 81 of the springs 79 and 80, and in which the ends 81 are seated. The free ends or tips 82 and 83 of bow springs 79 and 80 pass through loop guides 84 and 85, respectively, cf.

FIG. 3, integrally formed on the edge of side cover 31. Each of the ZIF connectors 50 has a long bow retention pocket 50P, cf. FIGS. 6, 7, 8A and 8B, formed in its base 52 at the end adjacent to the actuator handle 50H. The operation of the assembly 10 and actuator mechanism 60 will next be described.

In operation, the assembly 10 is readied for receiving its cassettes 30 by positioning the handles 50H of each pair of aligned upper and lower ZIF connectors 50, which is to receive a cassette 30, to their horizontal open positions. This places the contacts 53 and 54 in their aforedescribed open positions for acceptance therebetween of the card 20 mounted in the particular cassette 30 in a non-obstructing manner. The handles 50H of each pair of aligned upper and lower ZIF connectors 50, which is not to receive a cassette 30, are positioned to their vertical positions thereby minimizing accidental insertion of a cassette 30 in the wrong pair of aligned connectors 50 and/or accidental insertion of a cassette 30 in a pair of non-aligned connectors 50 in a skewed manner, e.g. the upper connector of one aligned pair and the lower connector of another aligned pair, which two last mentioned pairs are adjacent to each other in the assembly 10. As previously explained, with the associated handle 50H in its vertical position, the opposed pair of contacts 53 and 54 of the empty ZIF connectors 50, i.e. those pair of aligned connectors 50 which are not to receive a cassette 30, are placed in their closed positions but do not touch each other and hence won't short circuit themselves. Moreover, with the handle 50H in the vertical position, it blocks entry of a card 20 into the connector 50 and hence prevents the card 20 from damaging the contacts 53, 54 in their closed position.

Each of the cassettes 30 to be installed as a part of the system of assembly 10 has the detents 71 of its actuator 60 located in the retracted position, i.e. in the detent notches 70. With the aid of handle 61-62, the cassette 30 is oriented with the leading edge 27 of the card 20 mounted therein facing the opening 16 of assembly 10 and the populated surface 22 positioned to the right as viewed facing FIG. 1. With the cassette 30 thus oriented, with the further aid of the handle 61-62, the upper and lower edges 23 and 24 of the card 20 are inserted in and guided by the respective channel guides 50G of the open, i.e. horizontally positioned, handles 50H of the pair of aligned ZIF connectors 50 selected to receive the card 20 of the particular cassette 30. As such, the upper and lower strips of the card 20, which extend outside the assembled covers 31 and 32 and on each of which strips are the two rows of I/O tabs 21 of the card 20, are ready for passage between the open contacts 53 and 54 of the upper and lower ZIF connectors 50, respectively, the EMI shield 32S of cover 32 being judiciously spaced from the card 20 so as to provide clearance of the ZIF connector 50 to allow free passage of the card 20 into and out of the connectors 50 without obstruction thereby of the card 20 and/or cassette 30.

Next, again with the aid of handle 61-62, the cassette 30 is moved in the X direction, cf. FIG. 1, whereupon the aforementioned strips of card 20 are guided by the channels 50G into the space located between the open opposing contacts 53 and 54, the edges 23 and 24 of card 20 being in sliding engagement with the edges 52E, cf. FIG. 9A, of the center portion of base 52 of the upper and lower ZIF connectors 50, respectively. The cassette 30 continues to be advanced in this manner in the X direction until the locator slots 28 and 28' on the leading edge 27 of the card 20 engage the aforementioned transverse locator pins, not shown, of the upper and lower connectors 50, respectively, which stops further advancement of the cassette 30 and card 20 in the X direction and provides a coarse retention of the card 20 in the X and Y directions.

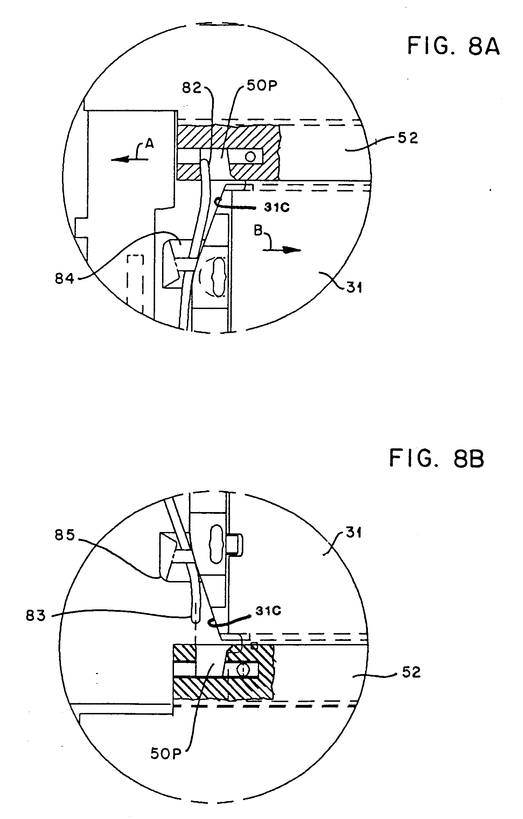

When this occurs, each of the tips 82 and 83 of the bow springs 79 and 80 is substantially aligned with the trai ling wall of the pocket 50P of the particular ZIF connector 50. For sake of clarity, the last described alignment, is only shown for the case of the lower bow spring 80, its tip 83 and pocket 50P of the lower connector 50 in FIGS. 7 and 8B. The gripping members 74 are then momentarily squeezed towards each other to allow retraction and release of the detents 71 from the notches 70 and thereby allowing the handle 61-62 to continue to be advanced in the X direction as the handle 61-62 is now free to slide on the guide 63. More particularly, the aforementioned locator pins, not shown, of the ZIF connectors 50 also act as stops when they engage the closed ends of the slots 28 and 28', which stops prevent further movement in the X direction of the card 20 and hence the cassette 30 in which it is mounted. As a result, the guide 63, which is affixed to the cover 31 of the cassette 30, is also stopped from movement in the X direction, whereupon further movement in the X direction of the handle 61-62 takes place as the glides 61G of cover 31 slide in the X direction between the rails 64, 65 and 66 of the now stopped guide 63.

As the handle 61-62 continues to so move in the X direction, the bow springs 79 and 80 carried thereby slideable engage the inclined corners 31C, FIGS. 8A-8B, of the stopped cover 31 causing their respective tips 82 and 83 to move into and to be engaged by the pockets 50P of the upper and lower ZIF connectors 50, whereupon the tips 82 and 83 are restrained thereby from further movement. As a result, as further movement in the X direction of the handle 61-62 progresses, the bow springs 79 and 80 begin to deflect, i.e. to bow. When the detents 71 reach the detent notches 69 and are biased therein by the action of spring 75, thus preventing further movement of the handle 61-62 in the X direction, the springs 79 and 80 are deflected and bowed, thereby providing the retention force for retaining the card 20 in the connectors 50. More particularly, the springs 79 and 80 provide a constantly applied retention force having one component, cf. arrow A, FIG. 8A, at their respective tips 82 and 83 against the trailing wall of the respective pockets 50P of the of the upper and lower connectors 50, respectively, and an opposite component, cf. arrow B, FIG. 8A, against the cover 31. For sake of clarity, only the case of the upper bow spring 79, its tip 82 and pocket 50P of the upper connector 50, when detents 71 are in the notches 69, is shown in FIGS. 6 and 8A.

The retention force, cf. arrows A and B, retains the cassette 30 and thus the card 20 mounted therein in the ZIF connectors 50 and prevents any omnidirectional movement of the card 20 and cassette 30. Thus, the card 20 and cassette 30 are restrained by apparatus 60 from movement in the classical six degrees of motion, that is against linear movement in the X, Y and Z directions, and against rotational movement about the X, Y and Z directions. Moreover, when the handles 50H of the connectors 50 are subsequently actuated to their respective vertical positions, the retention apparatus 60 securely retains the cassette 30 and its card 20 against any and all movements thereof in the aforementioned six degrees of motion, i.e the three linear and three rotational movements, which the forces created by the wiping action of the contacts 53 and 54 against the I/O pads 21, 21' might tend to induce.

To remove a cassette 30 from the system of assembly 10, the handles 50H of the upper and lower connectors 50 are returned to their horizontal position. The gripping members 74 are squeezed together overcoming the bias of spring 75 to clear and release the detents 71 from the notches 69. Spring 78, which was compressed when the handle 61-62 was moved in the X direction along the guide 63, urges the handle 61 in the reverse direction along the guide 63 until the detents 71 engage the notches 70 and urged therein by the bias of spring 75. As the handle 61-62 travels in the reverse X direction from notch 69 to notch 70 the bow springs 79 and 80 contract to their normal positions and configurations, thus removing the tips 82 and 83 from the pockets 50H of the upper and lower connectors 50, respectively.

As can be readily appreciated by one skilled in the art, the retention apparatus 60 is easily operable and user friendly, as the insertion of the cassette 30 in the system of assembly 10 and actuation of the retention system 10 takes place in the same direction and with substantially one motion using the handle 61-62. The same is true for releasing the retention system 60 and withdrawing the cassette 30 from the system of assembly 10 which takes place in the reverse direction and with substantially one motion using the handle 61-62.

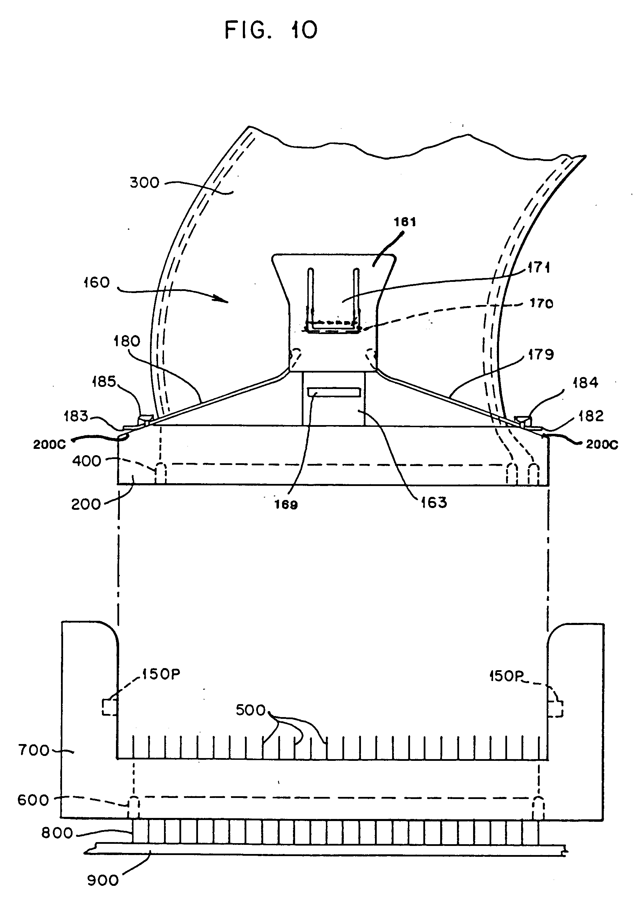

In FIG. 10, there is shown another embodiment of the retention apparatus of the present invention used in a connector system. In the embodiment of FIG. 10, the retention apparatus, generally indicated by the reference numeral 160, has a hollow handle 161 similar to the handle 61-62 of the previously described retention apparatus associated with FIGS. 5-7, 8A-8B. Handle 161 has an L-shaped resilient detent 171 which is inwardly biased and is engagable with the detent notches 169 and 170 formed in the side of guide 163 that extends into the handle 161. In the embodiment of FIG. 10, guide 163 is affixed to the insulator receptacle housing 200 that carries a row of schematically shown female terminals 400 mounted therein, each of which is connected to one of the conductors of the multi-conductor flat cable 300. Terminals 400 mate with the pins 500 mounted in a U-shaped insulator pin header 700, each pin 500 terminating in a female terminal 600 that mates with the I/O pins 800 of a printed circuit board 900 or the like. Generally, the header 700 is mechanically secured to the board 900 by suitable fastening means, not shown.

The handle 161 of the actuator apparatus 160 carries therein bow springs 179 and 180 similar to the manner in which the bow springs 79 and 80 are carried in the handle 61-62 of the first described embodiment. The bow springs pass through the guides 184 and 185 affixed to housing 200. The tips 182 and 183 are adapted to engage the pockets 150P located in the sides of the pin header 700.

In operation, to engage the pins 500 with the terminals terminals 400, the detent 171 is located in notch 170. Then, with the aid of handle 161, the housing 200 with its terminals 400 facing the pins 500 is advanced towards header 700 between the two vertical arms of header 700. As such, the pins 500 plug into the mating terminals 400 and when the housing 200 and header 700 are in substantial contact along their elongated horizontal interface, movement of the housing 200 towards the header 700 stops, and the tips 182 and 183 are in substantial alignment with the trailing wall of the detent pockets 150P. Detent 171 is now released from the trailing edge notch 170 and the handle 161 is further advanced towards header 700 as it slides on the guide 163. As handle 161 is so advanced, it deflects and bows the springs 179 and 180 causing the tips 182 and 183 to slide along the tapered corners 200C of the connector 200 and into the pockets 150P. When the detent 171 carried by handle 161 reaches and is engaged by leading edge notch 169, the deflected and bowed springs 179 and 180 provide a constantly applied retention force with a component that acts against in the upward direction on the header 700 at the interface of the tips 182, 183 and the respective trailing wall of the pockets 150H, and another component which acts in the opposite direction at the interface of the springs 179, 180 and the housing 200 in proximity to the guides 184 and 185, in a manner substantially identical to the retaining force produced by the retention apparatus 60 as shown by the arrows A and B in FIG. 8A of the last mentioned embodiment. Apparatus 160 thus securely retains and seats the mating cable header female receptacle housing 200 to the pin he ader 700 and hence securely retains the terminals 400 to their respective pins 500, thereby providing a highly reliable connector system.

Alternatively, the header 700 may be a pinless header or shroud secured to the board 900 , e.g. by screws, with the pins 800 of the board 900 extending therethrough so that the the terminals 400 of the connector 200 mate directly with the pins 800. As can be appreciated by those skilled in the art, the connector 200 can also be modified to be a male connector, e.g. a pin type, with the header 700 being modified to be a female type having mating female terminals for the male terminals of the last mentioned modified connector 200.

As is readily appreciated by those skilled in the art, the retention apparatus of the present invention may be modified so that instead of using a pair of separate springs, i.e. springs 69 and 70 of apparatus 60 or springs 169 and 170 of apparatus 160, a single spring extending outwardly from both sides of the handle may be used. Moreover, the retention apparatus may be modified so that the handle, i.e. handle 61-62 of apparatus 60 or the handle 161 of apparatus 160 is normally biased towards the free end of the handle, e.g. wall 76 in the case of handle 61-62, so that the trailing notches, i.e notches 70 of apparatus 60 or the trailing notch 170 of apparatus 160, are eliminated. This bias could be provided by the spring 75 in the case of the apparatus 60. Moreover, while the elements of actuators 60 and/or 161 are arranged in a symmetrical manner, it should be understood that the elements thereof may be arranged asymmetrically as well, as will be appreciated by those skilled in the art. Also, the retention apparatus can be used to hold and seat other electrical and/or electronic objects, as well as non-electrical and non-electronic devices.

## Claims

1. Retention apparatus (60; 160) for retaining a first object (20; 400) in a predetermined position with respect to a second object (50; 700) when inserted into said second object, said apparatus comprising:

   movable member means (30; 200) housing said first object for moving said object in a first direction (X) towards said predetermined position,

   guide means (63; 163) mounted to said movable member means (30; 200),

   actuator means (61-62; 161) for actuating said movable member means, said actuator means being operably movable in said first direction and slideably engagable with said guide means,

   stop means (28, 28') for stopping the movement of said object in said first direction at said predetermined position,

   gripping means (74; 171) arranged on said actuator means and being engagable with said guide means,

   resilient member means (79-80; 179-180) extending outwardly from said actuator means and incident to said first direction, said actuator means being further operably movable in said first direction when said object is stopped by said stop means, said resilient member means being deflected when at said predetermined position by further movement in said first direction of said actuator means and said gripping means when said object is stopped by said stop means,

   said actuator means being placed in sliding engagement with said guide means to provide said further movement in said first direction when said object is stopped by said stop means,

   said deflection of said resilient member means being responsive to said sliding engagement,

   said deflection of said resilient member means biasing at least one free end (82, 83; 182, 183) of said resilient member means engaging with respective pockets (50P; 150P) in a second object at the end of said further movement to prevent displacement of said first object at said predetermined position, and

   said biasing by said deflection of said resilient member means of said first object in said first direction at said predetermined position providing a force (A-B) to prevent omnidirectional linear and rotational said displacement of said first object.

2. The apparatus of claim 1 wherein:

   said object is a printed circuit card (20) having at least one row of plural input/output pads (21, 21') located on at least one surface (22) of said card and adjacent a predetermined edge (23, 24) of said card,

   said apparatus retaining said card with respect to an edge connector (50) having plural mating spring contacts (53, 54) adapted to receive said edge of said card with said input/output pads,

   said card being carried and moved by said movable member means in said first direction towards said connector and said contacts, said contacts being in a retracted open first position for non-obstructing passage of said edge of said card and said input/output pads adjacent said edge.

3. The apparatus of claim 1 wherein:

   said object is a printed circuit card (20) having at least one row of plural input/output pads (21, 21') located on each planar surface of said card and adjacent to at least two opposite first and second edges (23, 24) of said card,

   said apparatus retaining said card with respect to two aligned spaced edge type first and second connectors (50), each said connector having first and second rows of plural mating sprng contacts (53, 54) adapted to receive one of said edges of said card with said input/output pads therebetween,

   said movable means (30) carrying said card to insert said first and second edges in said first direction (X) between said first and second row of said contacts of said first and second connectors, respectively, said contacts of said first and second connectors being in a retracted open first positions for non-obstructing passage therebetween of said first and second edges of said card and said input/output pads adjacent said edges.

4. Apparatus according to claim 2 or 3 wherein:

   said spring contacts of said connectors wipe said mating input/output pads upon closure of said spring contacts from said open first positions to closed biased second positions against said pads, said force preventing any said omnidirectional displacement of said card resulting from the wiping action of said spring contacts with said pads.

5. An electronic component assembly (10) comprising:

a plurality of predetermined printed circuit cards (20) disposed in a planar parallel aligned relationship, each of said first printed circuit cards having at least one first row of plural input/output pads (21, 21') located on at least one first surface of said card and adjacent a predetermined first edge of said card,

a plurality of elongated zero insertion force first connectors (50), each of said connectors having plural mating spring contacts (53, 54) adapted to receive said first edge of one of said cards and said input/output pads thereof,

a first printed circuit board (40) having said first connectors mounted in aligned parallel relationship to a first surface (41) of said first board, and

a plurality of retention apparatus (60), each said apparatus comprising:

a plurality of cassette means (30), each of said cassette means carrying one of said cards in a first direction (X) towards a said first connector for insertion of said first edge and said first row of pads thereof into said first connector, said contacts of said first connector being in a retracted open first position for non-obstructing passage therein of said edge of said card and said input/output pads adjacent said first edge,

guide means (63) mounted to said cassette means,

handle actuator means (61-62) for actuating said cassette means, said actuator means being operably movable in said first direction and slideably engagable with said guide means,

stop means (28, 28') for stopping the movement of said cassette means in said first direction when said input/output pads of said first board carried thereby are in aligned registration with the mating contacts of said first connector,

gripping means (74) arranged outside said handle actuator means and being engagable with said guide means,

resilient bow spring means (79-80) extending outwardly from said handle actuator means and incident to said first direction, said actuator means being placed in sliding engagement with said guide means for further operable movement in said first direction when said card is stopped by said stop means, said resilient spring means being deflected when at said predetermined position by further movement in said first direction of said actuator means as said actuator means slides in said sliding engagement,

said deflection of said resilient spring means biasing at least one free end (82, 83) of said resilient member means engaging with respective pockets (50P) in said first connectors (50) at the end of said further movement in said first direction at said predetermined position with a constantly applied force (A-B) to prevent omnidirectional linear and rotational displacement of said card carried by said cassette means.

6. The assembly according to claim 5 wherein:

said spring contacts of each said first connectors wipe said input/output pads upon closure of said spring contacts from said open first position to a closed biased second position against said pads, said force preventing any said omnidirectional displacement of said card resulting from the wiping action of said spring contacts with said pads.

7. The assembly (10) of claim 5, wherein said assembly further comprises:

each of said printed circuit cards having at least one second row of plural input/output pads (21, 21') located on said first surface of said card adjacent a second edge of said card opposite said first edge, each of said cards having at least one third and fourth rows of input/output pads located on the opposite second surface of said card, said third and fourth rows being adjacent to said first and second edges, respectively, of said card,

a second printed circuit board (40) disposed in spaced planar parallel aligned relationship with said first board,

a plurality of zero insertion force second connectors (50) mounted in aligned parallel relationship to a first surface of said second board, each of said second connectors being paired with a mutually exclusive one of said first connectors, said first and second connectors of each pair being aligned in parallel and in facing relationship to each other on said respective first surfaces (41) of the first and second boards, respectively, each said first connector of a said pair having first and second rows of plural mating opposing said spring contacts (53, 54) adapted to receive therebetween said first edge of a said card and said first and third rows of said input/output pads adjacent to said first edge, and each said second connector of a said pair having first and second rows of plural mating opposing mating spring contacts (53, 54) adapted to receive therebetween said second edge of a said card and said second and fourth rows of said input/output pads adjacent to said second edge, and

each of said cassette means (30) further concurrently inserting in said first direction said first edge of said card carried thereby and said first and third rows of said pads between said first and second opposing contacts of said first connector of the pair and said second edge of said card carried thereby and said second and fourth rows of said pads between said first and second contacts of said second connector paired with the particular said first connector, said contacts of said second connectors being in a retracted open first positions for nonobstructing passage therebetween of said second edge of said card and said input/output pads adjacent said second edge,

said first and third rows of said pads of a said card being adapted to mate with the first and second rows, respectively, of said first connector of the pair, and said second and fourth rows of said pads of a said card being adapted to mate with the first and second rows, respectively, of said second connector of the pair,

all of said input/output pads of said card being carried by said cassette means being in aligned registration with their respective said mating contacts when said stop means (28, 28') stops said movement of said cassette means.

8. The assembly according to claim 7 wherein:
said spring contacts of said connectors wipe said mating input/output pads upon closure of said spring contacts from said open first positions to closed biased second positions against said pads, said force preventing any said omnidirectional displacement of said card resulting from the wiping action of said spring contacts with said pads.

**Revendications**

1. Dispositif de retenue (60;160) pour retenir un premier objet (20;400) dans une position prédéterminée par rapport à un deuxième objet (50;700) lorsqu'il est inséré dans ledit deuxième objet, ledit dispositif comprenant :

une cassette mobile (30:200) contenant ledit premier objet, pour déplacer ledit objet dans une première direction (X) vers ladite position prédéterminée,

des moyens de guidage (63;163) montés sur ladite cassette mobile (30;200),

des moyens de manoeuvre (61-62;161) pour actionner ladite cassette mobile, lesdits moyens de manoeuvre étant fonctionnellement déplaçables dans ladite première direction et pouvant s'accoupler de façon coulissante avec lesdits moyens de guidage,

des moyens de butée (28,28') pour arrêter le mouvement dudit objet dans ladite première direction, à ladite position prédéterminée,

des moyens d'enclenchement (74;171) prévus sur lesdits moyens de manoeuvre et pouvant venir en prise avec lesdits moyens de guidage,

des éléments élastiques (79-80;179-180) s'étendant vers l'extérieur à partir desdits moyens de manoeuvre et orientés dans ladite première direction, lesdits moyens de manoeuvre pouvant effectuer un mouvement supplémentaire dans ladite première direction lorsque ledit objet est arrêté par lesdits moyens de butée, lesdits éléments élastiques étant fléchis, lorsqu'ils sont à ladite position prédéterminée, par un mouvement supplémentaire desdits moyens de manoeuvre et desdits moyens d'enclenchement dans ladite première direction lorsque ledit objet est arrêté par lesdits moyens de butée,

lesdits moyens de manoeuvre étant placés en engagement coulissant avec lesdits moyens de guidage pour engendrer ledit mouvement supplémentaire dans ladite première direction lorsque ledit objet est arrêté par lesdits moyens de butée,

ladite flexion desdits éléments élastiques répondant audit engagement coulissant,

ladite flexion desdits éléments élastiques pressant au moins une extrémité libre (82,83;182,183) des dits éléments élastiques en prise avec des poches respectives (50P;150P) dans un deuxième objet, à la fin dudit mouvement supplémentaire, afin d'empêcher un déplacement dudit premier objet se trouvant à ladite position prédéterminée, et

ladite pression,par ladite flexion desdits éléments élastiques, dudit premier objet dans ladite première direction,à ladite position prédéterminée, engendrant une force (A-B) qui empêche ledit déplacement omnidirectionnel, linéaire et en rotation dudit premier objet.

2. Dispositif suivant la revendication 1, dans lequel

ledit objet est une carte de circuit imprimé (20) comportant au moins une rangée de plusieurs plots d'entrée/sortie (21,21') situés sur au moins une surface (22) de ladite carte et près d'un bord prédéterminé (23,24) de ladite carte,

ledit dispositif retenant ladite carte par rapport à un connecteur de bord (50) comportant plusieurs contacts élastiques coopérants (53,54) prévus pour recevoir ledit bord de ladite carte avec lesdits plots d'entrée/sortie,

ladite carte étant portée et déplacée par la dite cassette dans ladite première direction vers ledit connecteur et lesdits contacts,lesdits contacts étant dans une première position rétractée ouverte pour le passage libre dudit bord de ladite carte et desdits plots d'entrée/sortie adjacents audit bord.

3. Dispositif suivant la revendication 1, dans lequel :

ledit objet est une carte de circuit imprimé (20) comportant au moins une rangée deplusieurs plots d'entrée/sortie (21,21') situés sur chaque surface plane de ladite carte et près d'au moins un premier et un deuxième bords opposés (23,24) de ladite carte,

ledit dispositif retenant ladite carte par rapport à un premier et un deuxième connecteurs alignés espacés (50), du type à montage sur bord, chaquedit connecteur comportant une première et une deuxième rangées de plusieurs contacts élastiques coopérants (53,54) qui peuvent recevoir entre eux un desdits bords de ladite carte avec lesdits plots d'entrée/sortie,

ladite cassette mobile (30) portant ladite carte pour insérer lesdits premier et deuxième bords dans ladite première direction (X) entre lesdites première et deuxième rangées de dits contacts desdits premier et deuxième connecteurs, respectivement, lesdits contacts desdits premier et deuxième connecteurs étant dans une première position rétractée ouverte pour un passage libre, entre eux, desdits premier et deuxième bords de ladite carte et desdits plots d'entrée/sortie adjacents auxdits bords.

4. Dispositif suivant la revendication 2 ou 3, dans lequel :

lesdits contacts élastiques desdits connecteurs essuient lesdits plots d'entrée/sortie coopérants, lors de la fermeture desdits contacts élastiques desdites premières positions ouvertes auxdites deuxièmes positions fermées, pressées contre lesdits plots, ladite force empêchant tout déplacement omnidirectionnel de ladite carte résultant de l'action d'essuyage desdits contacts élastiques sur lesdits plots.

5. Assemblage de composants électroniques (10) comprenant :

une pluralité de cartes de circuit imprimé prédéterminées (20) disposées en alignement parallèle plan, chacune desdites premières cartes de circuit imprimé comportant au moins une première rangée de plusieurs plots d'entrée/sortie (21,21') situés sur au moins une première surface de ladite carte et adjacents à un premier bord prédéterminé de ladite carte,

une pluralité de premiers connecteurs allongés (50) à force d'insertion nulle, chacun desdits connecteurs comportant plusieurs contacts élastiques coopérants (53,54) qui peuvent recevoir ledit premier bord d'une desdites cartes et ses plots d' entrée/sortie,

une première carte de circuit imprimé (40), ayant lesdits premiers connecteurs montés en relation parallèle alignée avec une première surface (41) de ladite première carte, et

une pluralité de dispositifs de retenue (60) chaque dit dispositif comprenant :

une pluralité de cassettes (30), chacune des dites cassettes portant une desdites cartes dans une première direction (X) vers undit premier connecteur pour insertion dudit premier bord et de sadite première rangée de plots dans ledit premier connecteur, lesdits contacts dudit premier connecteur étant dans une première position rétractée ouverte pour le passage libre dudit bord de ladite carte et desdits plots d'entrée/sortie adjacents audit premier bord,

des moyens de guidage (63) montés sur ladite cassette,

des moyens de manoeuvre à poignée (61,62) pour actionner ladite cassette, lesdits moyens de manoeuvre étant fonctionnellement déplaçables dans ladite première direction et pouvant s'engager de façon coulissante avec lesdits moyens de guidage,

des moyens de butée (28,28') pour arrêter le mouvement de ladite cassette dans ladite première direction lorsque lesdits plots d'entrée/sortie de ladite première carte ainsi transportée sont en alignement avec les contacts coopérants dudit premier connecteur,

des moyens d'enclenchement (74) prévus à l'extérieur desdits moyens de manoeuvre à poignée et pouvant venir en prise avec lesdits moyens de guidage,

des éléments élastiques arqués (79-80) s'étendant vers l'extérieur à partir desdits moyens de manoeuvre à poignée et orientés dans ladite première direction, lesdits moyens de manoeuvre étant placés en engagement coulissant avec lesdits moyens de guidage pour un mouvement supplémentaire dans ladite première direction lorsque ladite carte est arrêtée par lesdits moyens de butée, lesdits éléments élastiques étant fléchis, lorsqu'ils sont à ladite position prédéterminée, par un mouvement supplémentaire desdits moyens de manoeuvre dans ladite première direction tandis que lesdits moyens de manoeuvre coulissent dans ledit engagement coulissant,

ladite flexion desdits éléments élastiques pressant au moins une extrémité libre (82,83) desdits éléments élastiques en engagement dans des poches respectives (50P) desdits premiers connecteurs (50) à la fin dudit mouvement supplémentaire dans ladite première direction, à ladite position prédéterminée, avec une force constamment appliquée (A-B) pour empêcher tout déplacement omnidirectionnel, linéaire et en rotation de ladite carte portée par ladite cassette.

6. Assemblage suivant la revendication 5, dans lequel :

lesdits contacts élastiques de chacun desdits premiers connecteurs essuient lesdits plots d'entrée/sortie lors de la fermeture desdits contacts élastiques de ladite première position ouverte à une deuxième position fermée pressée contre lesdits plots, ladite force empêchant tout déplacement omnidirectionnel de la dite carte résultant de l'action d'essuyage desdits contacts élastiques sur lesdits plots.

7. Assemblage (10) suivant la revendication 5, dans lequel ledit assemblage comprend en outre :

chacune desdites cartes de circuit imprimé comportant au moins une deuxième rangée de plusieurs plots d'entrée/sortie (21,21') situés sur ladite première surface de ladite carte près d'un deuxième bord de ladite carte opposé audit premier bord, chacune des dites cartes comportant au moins une troisième et une quatrième rangées de plots d'entrée/sortie situés sur la deuxième surface opposée de ladite carte, lesdites troisième et quatrième rangées étant adjacentes auxdits premier et deuxième bords, respectivement, de ladite carte,

une deuxième carte de circuit imprimé (40) disposée en alignement parallèle plan espacé avec ladite première carte,

une pluralité de deuxièmes connecteurs à force d'insertion nulle (50) montés en relation parallèle alignée avec une première surface de ladite deuxième carte, chacun desdits deuxièmes connecteurs étant associé en paire avec un connecteur mutuellement exclusif desdits premiers connecteurs, lesdits premier et deuxième connecteurs de chaque paire étant alignés en parallèle et mutuellement en regard sur lesdites premières surfaces respectives (41) des première et deuxième cartes, respectivement, chaque dit premier connecteur d'une dite paire comportant une première et une deuxième rangées de plusieurs dits contacts élastiques coopérants opposés (53,54) qui peuvent recevoir entre eux ledit premier bord d'une dite carte et lesdites première et troisième rangées dedits plots d'entrée/sortie adjacents audit premier bord et chaque dit deuxième connecteur d'unedite paire comportant une première et une deuxième rangées de plusieurs contacts élastiques coopérants opposés (53,54) qui peuvent recevoir entre eux ledit deuxième bord d'unedite carte et lesdites deuxième et quatrième rangées de dits plots d'entrée/sortie adjacents audit deuxième bord, et

chacune desdites cassettes (30) insérant en outre simultanément dans ladite première direction ledit premier bord de ladite carte ainsi transportée et les dites première et troisième rangées dedits plots entre lesdits premiers et deuxièmes contacts opposés dudit premier connecteur de la paire, et ledit deuxième bord de la dite carte ainsi transportée et lesdites deuxième et quatrième rangées dedits plots entre lesdits premiers et deuxièmes contacts dudit deuxième connecteur en paire avec ledit premier connecteur considéré, lesdits contacts desdits deuxièmes connecteurs étant dans une première position rétractée ouverte pour un passage libre, entre eux, dudit deuxième bord de ladite carte et desdits plots d'entrée/sortie adjacents audit deuxième bord,

lesdites première et troisième rangées dedits plots d'une dite carte étant prévues pour coopérer avec les première et deuxième rangées, respectivement, dudit premier connecteur de la paire, et lesdites deuxième et quatrième rangées dedits plots d'unedite carte étant prévues pour coopérer avec les première et deuxième rangées, respectivement, dudit deuxième connecteur de la paire,

tous lesdits plots d'entrée/sortie de ladite carte portée par ladite cassette étant alignés avec leurs dits contacts coopérants respectifs lorsque lesdits moyens de butée (28,28') arrêtent ledit mouvement de ladite cassette.

8. Assemblage suivant la revendication 7, dans lequel :

lesdits contacts élastiques desdits connecteurs essuient lesdits plots d'entrée/sortie coopérants, lors de la fermeture desdits contacts élastiques de ladite première position ouverte à ladite deuxième position fermée pressée contre lesdits plots, ladite force empêchant tout déplacement omnidirectionnel de ladite carte résultant de l'action d'essuyage desdits contacts élastiques sur lesdits plots.

**Patentansprüche**

1. Arretierungsvorrichtung (60; 160) zum Halten eines ersten Gegenstandes (20; 400) in einer vorbestimmten Lage bezüglich eines Zweiten Gegenstandes (50; 700), wenn er in den zweiten Gegenstand eingesetzt wird, wobei die Vorrichtung umfaßt:

bewegliche Bauteilmittel (30; 300) zum Unterbringen des ersten Gegenstandes, um ihn in einer ersten Richtung (X) in die vorbestimmte Lage zu bewegen,

Führungsmittel (63; 163), die auf den beweglichen Bauteilmitteln (30; 200) befestigt sind,

Betätigungsmittel (61 - 62; 161) zum Betätigen der beweglichen Bauteilmittel, wobei die Betätigungsmittel im Betrieb in der ersten Richtung bewegbar und gleitend mit den Führungsmitteln in Eingriff zu bringen sind,

Anhaltemittel (28, 28') zum Anhalten der Bewegung des Gegenstandes in der ersten Richtung in der vorbestimmten Lage,

Greifermittel (74; 171), die auf den Betätigungsmittel angeordnet sind und mit den Führungsmitteln in Eingriff bringbar sind,

Federmittel (79 - 80; 179 - 180), die sich von den Betätigungsmitteln nach außen erstrecken und in der ersten Richtung verlaufen, wobei die Betätigungsmittel ferner im Betrieb in der ersten Richtung bewegbar sind, wenn der Gegenstand durch die Anhaltemittel angehalten wird, wobei die Federmittel, wenn sie sich in der vorbestimmten Lage befinden, durch weitere Bewegung der Betätigungsmittel und der Greifermittel in der ersten Richtung ausgelenkt werden, wenn der Gegenstand durch die Haltemittel angehalten wird,

wobei die Betätigungsmittel für gleitenden Eingriff mit den Führungsmitteln angebracht sind, um für die weitere Bewegung in der ersten Richtung zu sorgen, wenn der Gegenstand durch die Haltemittel angehalten wird,

wobei die Auslenkung der Federmittel auf das gleitende Eingreifen anspricht und

das Auslenken der Federmittel zumindest ein freies Ende (82, 83; 182, 183) der Federmittel vorspannt, die mit entsprechenden Fächern (50P; 150P) in einem zweiten Gegenstand am Ende der weiteren Bewegung in Eingriff kommen, um das Verschieben des ersten Gegenstandes an der vorbestimmten Lage zu verhindern, und

das Vorspannen durch das Auslenken der Federmittel des ersten Gegenstandes in der ersten Richtung an der vorbestimmten Lage eine Kraft (A-B) liefert, um in jeder Richtung eine lineare und eine drehende Verschiebung des ersten Gegenstandes zu verhindern.

2. Vorrichtung nach Anspruch 1, bei der der Gegenstand eine Karte (20) mit gedruckten Leiterzügen ist, die zumindest eine Reihe Eingangs-/Ausgangskontaktflecken (21, 21') aufweist, die sich auf zumindest einer Fläche (22) der Karte und unmittelbar benachbart zu einem vorgegebenen Rand (23, 24) der Karte befinden,

wobei die Vorrichtung die Karte im Hinblick auf einen Randverbinder (50) hält, der mehrere zusammengehörige Kontaktfedern (53, 54) aufweist, die geeignet sind, den Rand der Karte mit den Eingangs-/Ausgangskontaktflecken aufzunehmen, wobei die Karte durch die bewegbaren Bauteilmittel getragen und in der ersten Richtung zu dem Verbinder und den Kontakten bewegt wird, wobei die Kontakte sich in einer zurückgenommenen, offenen ersten Lage für das ungehinderte Passieren des Randes der Karte und der Eingangs-/Ausgangskontaktflecken in unmittelbarer Nachbarschaft des Randes befinden.

3. Vorrichtung nach Anspruch 1, bei der

der Gegenstand eine Karte (20) mit gedruckten Leiterzügen ist, die zumindest eine Reihe von mehrfachen Eingangs-/Ausgangskontaktflecken (21, 21') aufweist, die sich auf jeder ebenen Fläche der Karte und in unmittelbarer Nachbarschaft zu zumindest zwei einander gegenüberliegenden ersten und zweiten Rändern (23, 24) der Karte befinden,

die Vorrichtung die Karte im Hinblick auf zwei ausgerichtete, im Abstand angeordnete erste und zweite Randverbinder (50) hält, wobei jeder Verbinder erste und zweite Reihen von mehrfachen zusammengehörigen Kontaktfedern (53, 54) aufweist, die geeignet sind, einen der Ränder der Karte mit den Eingangs-/Ausgangskontaktflecken dazwischen aufzunehmen,

die bewegbaren Mittel (30) die Karte tragen, um die ersten und zweiten Ränder in der ersten Richtung (X) zwischen der ersten und zweiten Kontaktreihe der ersten und zweiten Verbinder einzusetzen, wobei die Kontakte der ersten und zweiten Verbinder sich in einer zurückgenommenen, offenen ersten Lage befinden für den ungehinderten Durchtritt der ersten und zweiten Ränder der Karte und der Eingangs-/Ausgangskontaktflecken, die den Rändern unmittelbar benachbart sind.

4. Vorrichtung nach Anspruch 2 oder 3, bei der die Kontaktfedern der Verbinder beim Schließen der Kontaktfedern von den offenen, ersten Positionen zu den geschlossenen, gegen die Kontaktflecken vorgespannten, zweiten Positionen über die zugehörigen Eingangs-/Ausgangskontaktflecken schleifen, wobei die Kraft jedes Verschieben der Karte, das aus dem Schleifen der Kontaktfedern auf den Kontaktflecken resultiert, in jeder Richtung verhindert.

5. Baugruppe (10) mit elektronischen Komponenten, die enthält:
eine Vielzahl vorgegebener Karten (20) mit gedruckten Leiterzügen, die planparallel ausgerichtet angeordnet sind, wobei jede der ersten Karten mit gedruckten Leiterzügen zumindest eine erste Reihe von mehrfachen Eingangs-/Aus-gangskontaktflecken (21, 21') aufweist, die sich zumindest auf einer ersten Fläche der Karte und in unmittelbarer Nachbarschaft zu einem vorgegebenen ersten Rand der Karte befinden,
eine Vielzahl von länglichen, kraftfrei einsetzbaren Verbindern (50), von denen jeder mehrere zusammengehörige Kontaktfedern (53, 54) aufweist, die geeignet sind, den ersten Rand einer der Karten und die darauf befindlichen Eingangs-/Ausgangskontaktflecken aufzunehmen,
eine erste Platine (40) mit gedruckten Leiterzügen, bei der die Verbinder parallel ausgerichtet zu einer ersten Fläche (41) der ersten Platine montiert sind, und
eine Mehrzahl von Arretierungsvorrichtungen (60), wobei jede Vorrichtung umfaßt:
eine Mehrzahl von Kassettenvorrichtungen (30), von denen jede eine der Karten in einer ersten Richtung (X) zu dem ersten Verbinder hin trägt für das Einsetzen des ersten Randes und der ersten Reihe von dessen Kontaktflecken in den ersten Verbinder, wobei die Kontakte des ersten Verbinders in einer zurückgenommenen, offenen ersten Position sich befinden zum ungehinderten Durchtritt des Randes der Karte und der Eingangs-/Ausgangskontaktflecken, die unmittelbar dem ersten Rand benachbart sind,
an der Kassettenvorrichtung befestigte Führungsmittel (63),
Griffbetätigungsmittel (61 - 62) zum Betätigen der Kassettenvorrichtung, wobei die Betätigungsmittel im Betrieb in der ersten Richtung bewegbar und gleitend mit den Führungsmitteln in Eingriff bringbar sind,
Anhaltemittel (28, 28') zum Anhalten der Bewegung der Kassettenvorrichtung in der ersten Richtung, wenn die von der ersten Platine getragenen Eingangs-/Ausgangskontaktflecken mit den zugehörigen Kontakten des ersten Verbinders ausgerichtet sind,
außerhalb der Griffbetätigungsmittel angeordnete Greifmittel (74), die mit den Führungsmitteln in Eingriff bringbar sind,
elastische Federbügelmittel (79 - 80), die sich von den Griffbetätigungsmitteln nach auswärts in der ersten Richtung erstrecken, wobei die Betätigungsmittel für gleitenden Eingriff mit den Führungsmitteln angeordnet sind zur weiteren Bewegung im Betrieb in der ersten Richtung, wenn die Karte durch die Anhaltemittel angehalten wird, wobei die elastischen Federmittel, wenn sie sich an der vorbestimmten Position befinden, durch weitere Bewegung des Betätigungsmittels in der ersten Richtung durchgebogen werden, wenn das Betätigungsmittel in den gleitenden Eingriff gleitet,
wobei die Durchbiegung der elastischen Federmittel zumindest ein freies Ende (82, 83) der Federmittel vorspannt, das mit den entsprechenden Fächern (50P) in den ersten Verbindern (50) am Ende der weiteren Bewegung in der ersten Richtung an der vorbestimmten Position mit einer konstant aufgebrachten Kraft (A-B) in Eingriff gelangt, um in jeder Richtung ein lineares und ein drehendes Verschieben der von der Kassettenvorrichtung getragenen Karte zu verhindern.

6. Baugruppe nach Anspruch 5, bei der die Federkontakte jedes der Verbinder auf den Eingangs-/Ausgangskontaktflecken beim Schließen der Federkontakte von der offenen, ersten Position in die geschlossene, vorgespannte zweite Position gegen die Kontaktflecken auf diesen schleifen, wobei die Kraft jedes Verschieben der Karte, das aus dem Schleifvorgang der Federkontakte auf den Kontaktflecken resultiert in jeder Richtung verhindert.

7. Baugruppe (10) nach Anspruch 5, die weiter enthält:
Karten mit gedruckten Leiterzügen, von denen jede zumindest eine zweite Reihe mit mehrfachen Eingangs-/Ausgangskontaktflecken (21, 21') aufweist, die auf der ersten Fläche der Karte unmittelbar benachbart zu einem zweiten Rand der Karte gegenüber dem ersten Rand angeordnet sind, wobei jede der Karten zumindest eine dritte und vierte Reihe von Eingangs-/Ausgangskontaktflecken aufweist, die auf der gegenüberliegenden zweiten Fläche der Karte angeordnet sind, wobei die dritten und vierten Reihen unmittelbar benachbart zu den ersten und zweiten Rändern der Karte angeordnet sind,
eine zweite Platine (40) mit gedruckten Leiterzügen, die planparallel im Abstand zu der ersten Platine angeordnet ist,
eine Mehrzahl von zweiten Verbindern (50) für kraftfreies Einsetzen, die parallel ausgerichtet zu einer ersten Fläche der zweiten Platine montiert sind, wobei jede der zweiten Verbinder mit einem der sich gegenseitig ausschließenden der ersten Verbinder gepaart ist und die ersten und zweiten Verbinder jedes Paares parallel und einander gegenüberliegend auf den entsprechenden ersten Flächen (41) der ersten und zweiten Platinen ausgerichtet sind, wobei der erste Verbinder eines Paares erste und zweite Reihen von mehrfachen, zusammengehörigen, einander gegenüberliegenden Federkontakten (53, 54) aufweist, die geeignet sind, zwischen sich den ersten Rand der Karte und die ersten und dritten Reihen der Eingangs-/Ausgangskontaktflecken aufzunehmen, die dem ersten Rand unmittelbar benachbart sind, und jeder zweite Verbinder eines Paares erste und zweite Reihen von mehrfachen zusammengehörigen einander gegenüberliegenden Federkontakten (53, 54) aufweist, die geeignet sind, zwischen sich den zweiten Rand der Karte und die zweiten und vierten Reihen von Eingangs-/Ausgangskontaktflecken, die dem zweiten Rand unmittelbar benachbart sind, aufzunehmen, und

jede der Kassettenvorrichtungen (30), die weiter gleichzeitig in der ersten Richtung den ersten Rand der von ihr getragenen Karte einsetzt und die ersten und dritten Reihen der Kontaktflecken zwischen den ersten und zweiten einander gegenüberliegenden Kontakten des ersten Verbinders des Paares und die zweiten und vierten Reihen der Kontaktflecken zwischen den ersten und zweiten Kontakten des zweiten Verbinders, der mit dem besonderen ersten Verbinder gepaart ist, wobei die Kontakte des zweiten Verbinders sich in einer zurückgenommenen ersten Position befinden für den ungehinderten Durchtritt des zweiten Randes der Karte und der Eingangs-/Ausgangskontaktflecken, die dem zweiten Rand unmittelbar benachbart sind,

und die ersten und dritten Reihen der Kontaktflecken der Karte geeignet sind, sich mit den ersten und zweiten Reihen des ersten Verbinders des Paares zu verbinden und die zweiten und vierten Reihen der Kontaktflecken einer Karte geeignet sind, sich mit den ersten und zweiten Reihen des zweiten Verbinders des Paares zu verbinden,

wobei alle die Eingangs-/Ausgangskontaktflecken der von der Kassettenvorrichtung getragenen Karte ausgerichtet sind mit ihren entsprechenden Kontakten, wenn das Haltemittel (28, 28') die Bewegung der Kassettenvorrichtung anhält.

8. Baugruppe nach Anspruch 7, bei der die Kontaktfedern der Verbinder beim Schließen der Kontaktfedern von der offenen, ersten Position in die geschlossene, gegen die Kontaktflecken vorgespannte zweite Position auf den entsprechenden Eingangs-/Ausgangskontaktflecken schleifen, wobei die Kraft jede Verschiebung der Karte in irgendeiner Richtung verhindert, die aus dem Schleifvorgang der Kontaktfedern auf den Kontaktflecken resultiert.

# FIG. 1

FIG. 2

# FIG. 3

FIG. 4A

FIG. 4B

FIG. 4D

FIG. 4F

FIG. 4C

FIG. 4E

FIG. 4G

FIG. 5

FIG. 6

FIG. 8A

50P

82

84

31

50H

74

79

70

71

69

81

FIG. 7

70  71  69

74  81

80

31

85

50P

83

50H

FIG. 8B

FIG. 8A

FIG. 8B

FIG. 9A

FIG. 9B

FIG. 10